# EUROPÄISCHE PATENTSCHRIFT

(11) **EP 1 067 448 B1**
(45) Veröffentlichungstag und Bekanntmachung des Hinweises auf die Patenterteilung: **11.02.2009**
(21) Anmeldenummer: 00113794.2
(22) Anmeldetag: 29.06.2000
(51) Int. Cl.: G06F 1/04

(54) **PC-System für Echtzeit- und Nicht-Echtzeitprogramme**
PC system for realtime and non-realtime programs
Système-PC pour programmes en temps réel et temps non réel

(30) Priorität: 08.07.1999 DE 19931933
(43) Veröffentlichungstag der Anmeldung: 10.01.2001
(73) Patentinhaber: SIEMENS AKTIENGESELLSCHAFT, 80333 München (DE)
(72) Erfinder: Ullrich, Joachim, Dr., 70563 Stuttgart (DE); Müller, Reiner, Dipl.-Ing. (FH), 91361 Pinzberg (DE); Willert, Josef, Dipl.-Ing., 91093 Hessdorf (DE)

(56) Entgegenhaltungen:
- WO-A-97/30516
- DE-A- 19 648 422
- JP-A- 01 314 451
- US-A- 4 137 504
- US-A- 5 808 494
- US-A- 5 915 108
- PATENT ABSTRACTS OF JAPAN & JP 01 314451 A
- GRUHLER, DREIER: "CANopen Implementation Guidelines" 1. Juli 1997 (1997-07-01), STA REUTLINGEN , REUTLINGEN, GERMANY

## Beschreibung

Die Erfindung bezieht sich auf ein Standard PC-System, dem ein interner Taktgeber zum Generieren eines Taktsignals zur Verfügung steht und bei dem über taktgesteuerte Schaltsignale kontinuierlich ein Wechsel zwischen einem Echtzeitprogramm und einem Nicht-Echtzeitprogramm innerhalb eines festen Zeittaktes erfolgt, wobei das Echtzeitprogramm die Steuerung und Regelung peripherer Geräte, insbesondere von Antrieben, erlaubt.

Für Steuerungsaufgaben werden zunehmend Standard PCs als Hardwareplattform eingesetzt. Die in diesen PCs installierten Betriebssysteme sind in der Regel für industrielle Anforderungen, beispielsweise für numerische Steuerungsaufgaben, nicht hinreichend echtzeitfähig. Die fehlende Eignung der PC-Betriebssysteme hat ihre Ursache darin, daß Dienste des Betriebssystems keine unter allen Betriebszuständen eingehaltenen maximalen Antwortzeiten garantieren.

Um dem abzuhelfen, kann neben dem PC-Betriebssystem für Nicht-Echtzeitprogramme ein Echtzeitbetriebssystem für Echtzeitprogramme installiert werden. Die Anwendungen, die harte Echtzeitanforderungen stellen, bedienen sich dann ausschließlich der Funktionen des Echtzeitbetriebssystems. Ein System der eingangs genannte Art hierzu ist aus der DE 196 48 422 A1 bekannt. Durch ein Taktsignal des PCs erfolgt dabei der fortlaufende Wechsel vom PC-Betriebssystem zum Echtzeitbetriebssystem.

Bei Echtzeitanwendungen zur Steuerung und Regelung ist ein zyklischer Datenverkehr zweckmäßig. Die Echtzeitanwendung, Ein- und Ausgabegeräte, z.B. Antriebe, bilden einen Regelkreis. Typischerweise arbeitet ein solcher Regelkreis mit einem konstanten Takt. Dieser Takt muß für alle Komponenten des Regelkreises konstant sein. Bei industrieller Anwendung ist stets eine größere Anzahl von peripheren Geräten, manchmal räumlich weitläufig mit dem PC verbunden. Der Datenverkehr erfolgt dann über ein Kommunikationssystem, z.B. Profibus oder Sercos. Dieses Kommunikationssystem muß die Übertragung der Daten im Takt sicherstellen. Der Erfinder hat nun erkannt, daß für den Gesamtprozeß, d.h. auch für den Wechsel Echtzeit zu Nicht-Echtzeit, das Kommunikationssystem den Takt vorgeben sollte, da hier die kritische Prozeßführung erfolgt.

Wenn sich also die Aufgabe stellt, ein System der eingangs genannten Art so auszubilden, daß ein möglichst reibungsloser Wechsel zwischen Echtzeit- und Nicht-Echtzeitanwendungen in einem industriellen Prozeß stattfinden soll, so wird diese Aufgabe gemäß der Erfindung dadurch gelöst, daß das PC-System über ein industrielles Kommunikationssystem, bei dem ein Busmaster die Kommunikationssteuerung übernimmt, mit einem vom PC-System unabhängigen zyklischen Kommunikationstakt mit den peripheren Geräten verbunden ist und daß aus dem Kommunikationstakt der feste Zeittakt generierbar ist.

Eine erste vorteilhafte Ausbildung der Erfindung ist dadurch gekennzeichnet, daß der feste Zeittakt indirekt aus dem Kommunikationstakt generierbar sind, indem dieser zunächst hinsichtlich seiner Taktzeit egalisiert wird. Damit wird ein äquidistanter Takt für das Umschalten auch dann aufrechterhalten, wenn in der Praxis übliche Taktzeitschwankungen im Kommunikationssystem auftreten.

In diesem Zusammenhang ist eine technisch äußerst einfach realisierbare Schaltungsanordnung dadurch gekennzeichnet, daß durch einen ersten Kommunikationstakt ein Zähler mit einer gegenüber dem Kommunikationstakt relativ hohen Frequenz durch Rücksetzen gestartet wird, daß um den zu erwartenden Zählerstand beim Eintreffen des nächsten regulären Kommunikationtaktes eine untere und eine obere Komperatorschwelle gesetzt sind, daß vor Erreichen der unteren Komperatorschwelle der Zähler nicht rücksetzbar ist, daß ab Erreichen der unteren Komperatorschwelle der Zähler durch einen neu eintreffenden Kommunikationstakt rücksetzbar ist, daß ansonsten bei Erreichen der oberen Komperatorschwelle ein automatisches Rücksetzen des Zählers erfolgt und daß durch die Rücksetzvorgänge der Zeittakt gegeben ist.

Das Umschaltsignal läßt sich aus einer solchen Schaltungsanordnung leicht dadurch erzeugen, daß bei einem definierten Zählerstand unterhalb der unteren Komperatorschwelle jeweils ein Umschaltsignal innerhalb des Zeittaktes vorgebbar ist.

Ein Ausführungsbeispiel der Erfindung ist in der Zeichnung dargestellt und wird im folgenden näher erläutert. Dabei zeigen:
In der Veröffentlichung "CANopen Implementation Guidelines", G. Gruhler, B. Dreier, Reutlingen, 01.07.1997 ist ein Kommunikationssystem zur Steuerung und Regelung von Antrieben offenbart.
In der DE 196 48 422 A1 ist ein Verfahren und eine Vorrichtung zum Implementieren eines echtzeitfähigen Steuerprogramms in einem nicht-echtzeitfähigen Betriebsprogramm offenbart.

FIG 1 ein Blockschaltbild,
FIG 2 ein erstes Funktionsdiagramm,
FIG 3 ein zweites Funktionsdiagramm und
FIG 4 ein Zählschaltungsprinzip

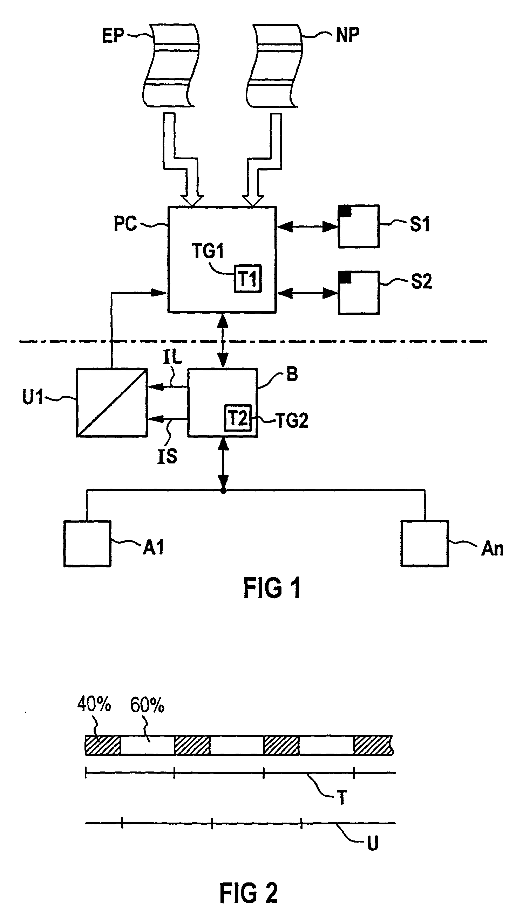

In der Darstellung gemäß FIG 1 sind in Form eines Blockschaubildes der Übersicht halber nur die für die Erfindung wesentlichsten Elemente gezeigt. Einem Personalcomputer PC, dem ein interner Taktgeber TG1 zum Generieren eines Taktsignals T1 zur Verfügung steht, und der mit nicht geschützten Speicherbereichen S1 und geschützten Speicherbereichen S2 ausgestattet ist, werden Echtzeitprogramme EP und Nicht-Echtzeitprogramme NP zugeleitet. Über den Modus der Zuleitung wird später noch einiges berichtet, ebenso über die Berücksichtigung der Speicherbereiche S1 und S2. Die Echtzeitprogramme EP dienen zum Abarbeiten von insbesondere Aufgaben der Antriebsregelung, während die Nicht-Echtzeitprogramme NP beispielsweise Visualisierungsaufgaben erledigen können.

Der Wechsel zwischen Echtzeitprogramm und Nicht-Echtzeitprogramm erfolgt zyklisch, wie in FIG 2 dargestellt. Jeweils mit Beginn eines Taktes eines äquidistanten Taktsignals T, wird das Echtzeitprogramm im Personalcomputer PC aktiviert, was durch Schraffur eines Signalbalkens im oberen Teil von FIG 2 angedeutet ist. Beispielsweise nach vierzig Prozent der Taktdauer des Taktsignals T wird dann jeweils in den Echtzeitbetrieb gewechselt, was durch ein Umschaltsignal U ausgelöst werden kann, wie dieses als zeitverzögertes Signal zum Taktsignal T im unteren Abschnitt von FIG 2 gezeigt ist. Der jeweils sechzigprozentige Anteil, des Nicht-Echtzeitbetriebs, in dem der Personalcomputer PC beispielsweise im Windows NT Betriebssystem befindlich ist, wird in der Darstellung gemäß FIG 2 durch die freien Balkenabschnitte angedeutet.

Zurück zu FIG 1. Durch eine strichpunktierte Linie ist die funktionelle Trennung des Personalcomputers PC zu einem industriellen Kommunikationssystem angedeutet, bei dem ein Busmaster B die Kommunikationsteuerung übernimmt, damit insbesondere den Antrieben A1 bis An im Takt des Kommunikationssystems fortlaufend Steuersignale zuleitbar sind. Dazu hat der Busmaster B einen Taktgeber TG2 für ein Taktsignal T2. Der Busmaster kann B aber auch an einer anderen Stelle des Kommunikationssystems, räumlich getrennt vom Personalcomputer PC, angeordnet sein und eine Busanbindung des Personalcomputers PC erfolgt dann über eine niederhierarchische Busanschaltbaugruppe, in der aber selbstverständlich der Takt T2 aus dem Bussignal heraus detektierbar ist.

Die Steuerungsaufgaben und der Bustakt sind, wie eingangs schon beschrieben wurde, für die erfindungsgemäße Arbeitsweise des Gesamtsystems prägend korreliert. Die Taktsignale T und die Umschaltsignale U, wie sie in FIG 2 gezeigt sind, werden bei der vorliegenden Erfindung nämlich aus dem Takt T2 des Bussystems generiert. Immer wenn ein Wechsel von einem Nicht-Echtzeitbetrieb in eine Echtzeitbetrieb erfolgen soll und immer wenn ein Wechsel vom Echtzeitbetrieb in den Nicht-Echtzeitbetrieb erfolgen soll, kann dann ein Interruptsignal über eine Interruptleitung IL ausgelöst werden und über eine Interruptspezifikationsleitung IS kann mitgeteilt werden, welcher der beiden Zustände vorliegt. Über einen Umsetzer U1 kann das Gesamtsignal dann an den Personalcomputer PC als ein geschachteltet Interrupt gemeldet werden, denn es wird nur ein einziger Interrupt der begrenzten Anzahl der Interrupt des Personalcomputers PC benötigt und durch die Spezifikationskennung wird dennoch eine Schachtelung erreicht, die selbstverständlich für weiter Aufgaben auch tiefer gehen kann, als die im Ausführungsbeispiel benutzte Anzahl zwei.

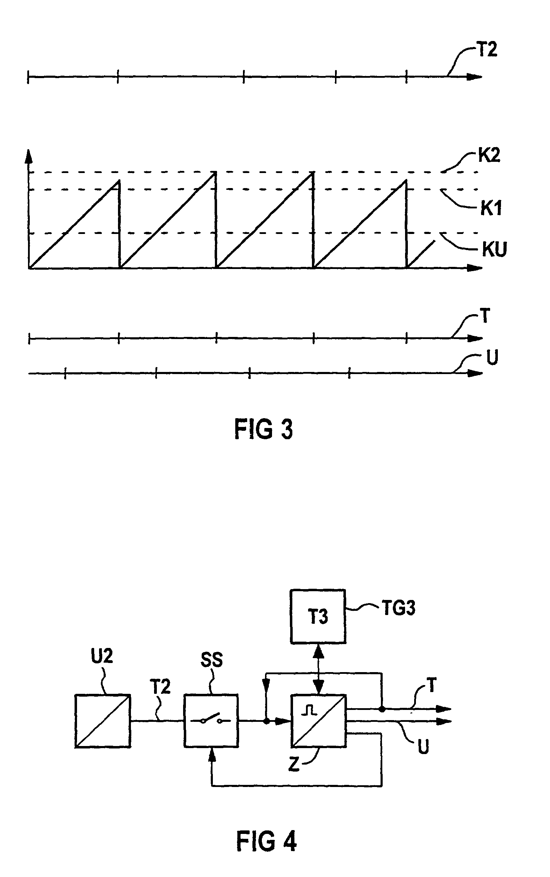

Insbesondere bei komplexen weitläufigen Systemen muss mit signifikanten Schwankungen und eventuell sogar Unterbrechungen des Taktsignals T2 gerechnet werden. In der Darstellung gemäß FIG 3 oben ist ein derartig gestörtes Taktsignal T2 gezeigt Damit der Personalcomputer PC diese Schwankungen jedoch nicht ausgesetzt wird, erfolgt eine Signalaufbereitung, deren Prinzip in der Schaltung gemäß FIG 4 gezeigt ist. So können die Taktsignale T2 beispielsweise durch einen Umsetzer U2 aus dem Bussignal gewonnen werden und gelangen dann über eine im Ruhezustand geschlossene Schaltstufe SS an einen Zähler Z, der in einem gegenüber dem Taktsignal T hochfrequenten Taktsignal T3 eines Taktgebers TG3 hochgezählt wird. Durch den ersten Takt des Taktsignals T2 wird der Zähler Z rückgesetzt und gestartet. Liegt an seinem Ausgang ein Zählerstand an der größer Null, aber kleiner als eine untere Komperatorschwelle K1 ist (gestrichelt in FIG 3 Mitte gezeigt), wird die Schaltstufe SS gesperrt. Ab Erreichen der unteren Komperatorschwelle K1 wird jedoch die Schaltstufe SS wieder durchgängig.

Wenn nun wieder ein Takt des Taktsignals T2 eintrifft, setzt er den Zähler zurück. Wenn jedoch dies nicht in Bälde erfolgt, erreicht der Zähler Z2 eine obere Komperatorschwelle K2 (in FIG 3 Mitte ebenfalls gestrichelt angedeutet), bei der in jeden Fall ein Rücksetzen des Zählers Z2 geschieht. Die obere und die untere Komperatorschwellen K2 und K1 sind um den Zählerstand für zeitgerecht eintreffende Taktsignale T2 herum angeordnet. Immer wenn ein Rücksetzen des Zählers Z2 erfolgt, wird ein Takt eines Taktsignals T ausgelöst.

Um auch einfach die Umschaltsignale U zu generieren, wird ein entsprechender Zählerstand für die Komperatorumschaltschwelle Kn festgelegt, wie dies ebenfalls in FIG 3 Mitte gezeigt ist.

Alle Zählerschwellen können mit Konfigurationswerten gesetzt werden und unverändert belassen werden, es ist aber prinzipiell auch möglich, Adaptionen vorzunehmen.

Im Ausführungsbeispiel gemäß FIG 3 erfolgen übrigens der erste (Start) und der zweite Takt des Taktsignals T2 so, dass dieses über Rücksetzen des Zählers Z entsprechende Taktsignale T erzeugen, während der dritte Takt des Taktsignals T2 so verspätet eintrifft, dass durch zuvoriges Erreichen der oberen Komperatorschwelle K2 der dritte Takt des Taktsignals T erzeugt wird. Gleiches gilt für den vierten Takt. Der fünfte Takt des Taktsignals T2 möge wieder regulär den fünften Takt des Taktsignals T auslösen.

Im folgenden mögen noch einige Ausführungen die Installation und Ausführung der jeweiligen Echtzeitanwendungen erläutern. Ferner wird noch einiges erläuternd zum Prinzip des geschachtelten Interrupts ausgeführt, der eingangs schon prinzipiell in seiner Wirkungsweise anhand des Ausführungsbeispiels behandelt worden ist.

Zum Installieren und Ausführen einer Echtzeitanwendung sei folgendes bemerkt. Das Echtzeitbetriebssystem, welches neben dem PC-Betriebssystem installiert wird, bietet ohne besondere Vorkehrungen keine Möglichkeit, interaktiv Echtzeitanwendungen zu starten, zu beenden oder in anderer Form zu beeinflussen. Die nachfolgend beschriebene Technik erlaubt das Starten einer Echtzeitanwendung in einem wie oben beschriebenen PC-System mit Echtzeiterweiterung durch Mechanismen des PC-Betriebssystems.

Die Echtzeitanwendung wird mit einem Entwicklungssystem für PC Anwendungen erstellt. Diese Anwendung kann mit den Standardmechanismen des PC-Betriebssystems gestartet werden. Für das PC-Betriebssystem handelt es sich bei der Echtzeitanwendung um ein gewöhnliches Programm. Nach dem Start der Echtzeitanwendung durchläuft diese eine Initialisierungsphase, in welcher noch keine echtzeitrelevanten Aktivitäten ausgeführt werden. In diesem Programmabschnitt meldet sich die Echtzeitanwendung über die Schnittstelle des Echtzeitbetriebssystems bei diesem an. Bei der Anmeldung werden die Eintrittpunkte in die echtzeitrelevanten Programmteile mitgeteilt. Nach Durchlaufen dieses Programmteils ist die Echtzeitanwendung bereit für den durch externe Signale gesteuerten Betrieb.

Wie gesagt, sind geschützte und ungeschützte Speicherbereiche S2 und S1 beim Personalcomputer PC vorgesehen. Zur Ausführung der Echtzeitanwendung in geschützter Umgebung sei daher noch folgendes bemerkt.

In PC Betriebssystemen (insbesondere Windows NT) wird jedes Programm in einer Umgebung ausgeführt, die unerlaubte Zugriffe zwischen Programmen und unerlaubte Zugriffe auf Systemdaten und Betriebsmittel verhindert (user-mode). Eine Echtzeitanwendung, die sich auf einen Echtzeitbetriebssystem abstützt, muss dagegen uneingeschränkten Zugriff auf alle vom Echtzeitsystem verwalteten Betriebsmittel haben. Das bedeutet, dass die Echtzeitanwendung in ungeschützter Umgebung (kernelmode) ablaufen muss. Ein Wechsel einer Anwendung vom geschützten in den ungeschützten Mode wird von den PC Betriebssystemen (Windows NT) nicht unterstützt.

Gemäß der Erfindung kann die folgend beschriebene Technik benutzt werden, damit unter dem PC Betriebssystem Windows NT ein Wechsel der Echtzeitanwendung vom geschützten in den ungeschützten Mode erreicht wird.

Für die Echtzeiterweiterung des PC Betriebssystems wird ein Gerätetreiber realisiert. Ein Gerätetreiber stellt eine Erweiterung des Betriebssystems dar. Das Programm des Gerätetreibers wird immer im ungeschützten (kernel-) Mode ausgeführt. Dieser Gerätetreiber der Echtzeiterweiterung bietet eine Schnittstelle, über die eine Anwendung (insbesondere auch eine Echtzeitanwendung) dem Gerätetreiber Funktionen (der Anwendung) mitteilen kann, die dieser dann aus dem ungeschützten Mode heraus aktivieren kann. (Zur Erklärung: Wird aus dem ungeschützten Mode eine Funktion aufgerufen, die zu einer Anwendung und damit zu einem geschützten Programmteil gehört, bleibt der ungeschützte Mode weiter aktiv.)

Die Ausführung von Funktionen der Echtzeitanwendung im ungeschützten Mode kann synchron erfolgen, d.h. die von der Echtzeitanwendung an den Treiber mitgeteilte Funktion wird direkt aktiviert, während der rufende Programmteil der Echtzeitanwendung an der Programmstelle stehen bleibt bis, das Programm aus der Treiberfunktion zurückkehrt. Eine solche synchrone Ausführung kann eingesetzt werden, wenn nach der Anmeldung der Echtzeitanwendung die weitere Initialisierung im ungeschützten Mode erfolgen soll (um z.B. uneingeschränkt auf die Betriebsmittel der Echtzeitanwendung zugreifen zu können).

Eine asynchrone Ausführung im ungeschützten Mode wird erreicht, wenn im Treiber die Funktionen der Echtzeitanwendung gespeichert werden und auf ein Signal hin diese Funktionen ausgeführt werden. Das Umschalten vom PC Betriebssystem in das Echtzeitbetriebssystem ist ein solcher asynchroner Aufruf einer Funktion des Echtzeitbetriebssystems im ungeschützten Mode: Das Umschaltsignal führt zur Aktivierung seiner zugeordneten Interruptbehandlungsroutine. Diese ist Teil des Treiberprogramms und wird im ungeschützten Mode ausgeführt. In dieser Interruptbehandlungsroutine erfolgt ein Wechsel in den Kontext der Echtzeitanwendung und eine dem Umschaltsignal zugeordnete Funktion der Echtzeitanwendung wird aktiviert.

Zu den geschachtelten Interrupts kann noch folgendes ergänzend ausgeführt werden. In einem PC System steht nur eine begrenzte Anzahl von Signalen für die Interruptbehandlung frei zur Verfügung. Von den fünfzehn Interruptsignalen des Standard-PCs sind die meisten durch Standardgeräte des PC-Systems belegt. Eine Echtzeitanwendung benötigt in der Regel mehrere Signale, auf die es mit kurzer Latenzzeit reagieren muss.

Übliche Praxis ist es, dass alle Signale, auf die die Echtzeitanwendung reagieren muss, durch eine Hardwareschaltung in einem Register gespeichert werden und jede Änderung im Register als ein Sammelsignal an den Interruptmechanismus des PCs weitergeleitet werden. In der diesem Sammelsignal zugeordneten Interruptbehandlungsroutine wird das Register ausgelesen und dadurch die Quelle der Interruptanforderung ermittelt. Bei einer größeren Anzahl von Echtzeitsignalen ist es notwendig, diese priorisiert zu behandeln, wobei höher priorisierte Echtzeitsignale die Behandlung von Echtzeitsignalen niedrigerer Priorität verdrängen.

Mehrere Echtzeitsignale über einen einzigen Interrupteingang des Standard PC zu behandeln, macht es erforderlich, dass diese geschachtelt abgearbeitet werden können. Die Interruptbehandlung von Windows NT sieht dieses nicht vor. Eine geschachtelte Behandlung von Interruptanforderungen auf der gleichen Interruptleitung wird durch erfindungsgemäße Technik auch unter PC Betriebssystemen möglich, die dieses nicht vorsehen.

Die Interruptbehandlungsroutine, die deren Sammelsignal der Echtzeitsignale zugeordnet ist, wird direkt in die Interrupt-Tabelle des Prozessors eingetragen. Dadurch wird die primäre Behandlung der Interruptanforderung durch Windows NT umgangen und muss durch eine entsprechende Behandlung in der Interruptbehandlungsroutine ersetzt werden. Insbesondere quittiert die Interruptbehandlungsroutine die Interruptanforderung beim Interruptmechanismus des PC, wodurch diese bereit gemacht wird, auf der gleichen Interruptleitung eine weitere Anforderung zu erzeugen. Die Interruptbehandlungsroutine, muss wiedereintrittsicher implementiert sein.

## Patentansprüche

1. Standard PC-System, dem ein interner Taktgeber (TG1) zum Generieren eines Taktsignals (T1) zur Verfügung steht und bei dem über taktgesteuerte Schaltsignale kontinuierlich ein Wechsel zwischen einem Echtzeitprogramm und einem Nicht-Echtzeitprogramm innerhalb eines festen Zeittaktes (T) erfolgt, wobei das Echtzeitprogramm die Steuerung und Regelung peripherer Geräte, insbesondere von Antrieben, erlaubt, **da durch gekennzeichnet**, daß das PC-System (PC,S1,S2) über ein industrielles Kommunikationssystem bei dem ein Busmaster (B) die Kommunikationssteuerung übernimmt mit einem vom PC-System (PC,S1,S2) unabhängigen zyklischen Kommunikationstakt (T2) mit den peripheren Geräten (A1,An) verbunden ist und daß aus dem Kommunikationstakt (T2) der feste Zeittakt (T) generierbar ist.

2. System nach Anspruch 1, **dadurch gekennzeichnet, daß** der feste Zeittakt (T) indirekt aus dem Kommunikationstakt (T2) generierbar sind, indem dieser zunächst hinsichtlich seiner Taktzeit egalisiert wird.

3. System nach Anspruch 2, **dadurch gekennzeichnet, daß** durch einen ersten Kommunikationstakt ein Zähler (Z) mit einer gegenüber dem Kommunikationstakt (T2) relativ hohen Frequenz durch Rücksetzen gestartet wird, daß um den zu erwartenden Zählerstand beim Eintreffen des nächsten regulären Kommunikationstaktes eine untere und eine obere Komperatorschwelle (K1, K2) gesetzt sind, daß vor Erreichen der unteren Komperatorschwelle (K1) der Zähler (Z) nicht rücksetzbar ist, daß ab Erreichen der unteren Komperatorschwelle (K1) der Zähler (Z) durch einen neu eintreffenden Kommunikationstakt rücksetzbar ist, daß ansonsten bei Erreichen der oberen Komperatorschwelle (K2) ein automatisches Rücksetzen des Zählers (Z) erfolgt und daß durch die Rücksetzvorgänge der Zeittakt (T) gegeben ist.

4. System nach Anspruch 3, **dadurch gekennzeichnet, daß** bei einem definierbaren Zählerstand (KU) unterhalb der unteren Komperatorschwelle (K1) jeweils ein Umschaltsignal (U) innerhalb des Zeittaktes (T) vorgebbar ist.

## Claims

1. Standard PC system to which an internal clock generator (TG1) is available for generating a clock signal (T1) and in which switching between a realtime program and a non-realtime program takes place continually within a fixed clock cycle (T) by way of clock-controlled switching signals, wherein the realtime program permits the open- and closed-loop control of peripheral devices, in particular drives,
**characterised in that** the PC system (PC, S1, S2) is connected to the peripheral devices (Al,An) via an industrial communication system in which a busmaster (B) is responsible for controlling the communication by means of a cyclical communication clock (T2) that is independent of the PC system (PC, S1, S2) and that the fixed clock cycle (T) can be generated from the communication clock (T2).

2. System according to claim 1, **characterised in that** the fixed clock cycle (T) can be generated indirectly from the communication clock (T2) by initially equalising the latter in terms of its cycle time.

3. System according to claim 2, **characterised in that** a counter (Z) having a relatively high frequency compared to the communication clock (T2) is started by resetting by means of a first communication clock, that a lower and an upper comparator threshold (K1,K2) are set around the counter reading that is to be expected when the next regular communication clock arrives, that the counter (Z) cannot be reset before the lower comparator threshold (K1) is reached, that from the time the lower comparator threshold (K1) is reached the counter (Z) can be reset by means a newly arriving communication clock, that otherwise the counter (Z) is reset automatically when the upper comparator threshold (K2) is reached, and that the clock cycle (T) is established by the reset operations.

4. System according to claim 3, **characterised in that** a switchover signal (U) can be predefined in each case within the clock cycle (T) at a definable counter reading (KU) below the lower comparator threshold (K1).

## Revendications

1. Système PC standard, auquel un générateur ( TGI ) interne de cadence est mis à disposition pour engendrer un signal ( TI ) de cadence et dans lequel, par des signaux de commutation commandés en cadence, un passage entre un programme en temps réel et un programme qui n'est pas en temps réel a lieu continuellement dans une cadence ( T ) de temps fixe, le programme en temps réel permettant la commande et la régulation d'appareils périphériques, notamment d'entraînements, **caractérisé en ce que** le système PC ( PC, S1, S2 ) est relié aux appareils ( A1, An ) périphériques par un système de communication industrielle, dans lequel un maître bus ( B ) prend en charge la commande de communication à une cadence ( T2 ) de communication cyclique, indépendante du système PC ( PC, S1, S2 ) et **en ce que** la cadence ( T ) de temps fixe peut être engendrée à partir de la cadence ( T2 ) de communication.

2. Système suivant la revendication 1, **caractérisé en ce que** la cadence ( T ) de temps fixe peut être engendrée indirectement à partir de la cadence ( T2 ) de communication par le fait que celle-ci est égalisée d'abord en ce qui concerne sa durée de cadence.

3. Système suivant la revendication 2, **caractérisé en ce que** par une première cadence de communication un compteur ( Z ), ayant une fréquence relativement haute par rapport à la cadence ( T2 ) de communication, est lancé par remise à l'état initial, **en ce que**, lorsque arrive la cadence de communication régulière suivante, un seuil ( K1 ) inférieur et un seuil ( K2 ) supérieur de compérateur sont mis autour de l'état du compteur auquel on s'attend, **en ce qu'**avant d'atteindre le seuil ( K1 ) inférieur de compérateur, le compteur ( Z ) ne peut pas être mis à l'état initial, **en ce qu'**après avoir atteint le seuil ( K1 ) inférieur de compérateur, le compteur ( Z ) peut être mis à l'état initial par une cadence de communication arrivant nouvellement, **en ce que** sinon, lorsque le seuil ( K2 ) supérieur de compérateur est atteint, une remise automatique à l'état initial du compteur a lieu et **en ce que** la cadence ( T ) de temps est donnée par les opérations de remise à l'état initial.

4. Système suivant la revendication 3, **caractérisé en ce que** pour un état ( KU ) du compteur pouvant être défini en dessous du seuil ( K1 ) inférieur de compérateur, respectivement un signal ( U ) de commutation peut être prescrit à l'intérieur de la cadence ( T ) de temps.
